Europäisches Patentamt

European Patent Office

Office européen des brevets

(19)

(11) **EP 0 525 242 B1**

(12) **EUROPÄISCHE PATENTSCHRIFT**

(45) Veröffentlichungstag und Bekanntmachung des Hinweises auf die Patenterteilung:
**17.01.1996 Patentblatt 1996/03**

(51) Int Cl.⁶: **H03H 11/04**, H03G 5/04

(21) Anmeldenummer: **91112907.0**

(22) Anmeldetag: **31.07.1991**

(54) **Filter mit einstellbarer Flankensteilheit**

Filter with controllable edge steepness

Filtre à raideur de flanc variable

(84) Benannte Vertragsstaaten:
**DE ES FR GB IT**

(43) Veröffentlichungstag der Anmeldung:
**03.02.1993 Patentblatt 1993/05**

(73) Patentinhaber:
**SIEMENS AKTIENGESELLSCHAFT**
**D-80333 München (DE)**

(72) Erfinder:
• **Wondra, Jürgen, Dipl.-Ing. (FH)**
**W-8011 Baldham (DE)**

• **Stepp, Richard, Dipl.-Ing.**
**W-8000 München 40 (DE)**

(56) Entgegenhaltungen:
**DE-A- 2 948 755**

• **ELECTRONIQUE ET APPLICATIONS INDUSTRIELLES, Nr. 257, Oktober 1978, Paris, FR, SS. 14-15; M. GILISSEN: 'Filtre passe-bande à haute sélectivité avec réjection de bruit'**
• **PATENT ABSTRACTS OF JAPAN vol. 5, no. 167 (E-79)(839) 24. Oktober 1981 & JP-A-56 096 518**

**Beschreibung**

Die Erfindung bezieht sich auf eine Filter mit einstellbarer Flankensteilheit.

Solche Filter sind allgemein bekannt und werden in den unterschiedlichsten Bereichen der Elektrotechnik eingesetzt. Z.b., De-A-2948755 [NIPPON GAKKI] Zeigt ein Beispiel eines Bandpass-Filters, welcher im besonderen für die Tonsteuerung geeignet ist. In dem Buch "Analoge und digitale IS" von Horst Pelka und Klaus Wetzel; Siemens-Aktiengesellschaft, Berlin; München; 1983 ist auf den Seiten 143 und 144 eine Klangregelschaltung mit dem integrierten Schaltkreis TDA 4290 von Siemens beschrieben. Bei dieser Klangregelschaltung lassen sich Lautstärke, Höhen und Tiefen mit Gleichspannung regeln. Die Charakteristik ist Umschaltbar von linearer auf physiologische und damit gehörrichtige Lautstärkeregelung. Für die physiologische Lautstärkeregelung ist der integrierte Schaltkreis extern mit einem frequenzabhängigen Netzwerk beschaltet, das über einen Schalter aktivierbar ist. Das frequenzabhängige Netzwerk muß dabei symmetrisch ohne Massebezug realisiert sein. Zugleich muß der integrierte Schaltkreis drei Anschlüsse für die physiologische Lautstärkeregelung vorsehen, nämlich zwei Anschlüsse für das frequenzabhängige Netzwerk und einen Anschluß für die Schalteinrichtung zum Aktivieren des frequenzabhängigen Netzwerkes. In Bild 6.2 der genannten Veröffentlichung sind dies die Anschlüsse 3, 4 und 6 des integrierten Schaltkreises TDA 4290. Nachteilig bei derartigen Klangregelschaltungen ist deren hochohmiger Ausgang sowie die im Silizium "festgelegte" Klangcharakteristik.

Problematisch bei einer weiteren realisierten Klangregelschaltung mit TDA 6200 ist die Verknüpfung der Lautstärkeeinstellung mit der Höhen-Tiefen-Regelung bei der physiologischen Lautstärkeregelung. Dies schränkt den frei verfügbaren Klangstellbereich ein.

Der Erfindung liegt die Aufgabe zugrunde, ein Filter anzugeben, das die obengenannten Nachteile nicht aufweist. Insbesondere soll das frequenzabhängige Netzwerk des Filters mit nur zwei Anschlüssen an eine integrierte Schaltung anschließbar sein und eine physiologische Lautstärkeregelung erlauben, die unabhängig von der Klangeinstellung ist.

Diese Aufgabe wird durch die Merkmale des Anspruchs 1 gelöst.

Weiterbildungen der Erfindung sind Gegenstand der Unteransprüche.

Die Übertragungsfunktion eines erfindungsgemäßen Filters ergibt sich aus dem Verhältnis der Ausgangsspannung $U_a$ zur Eingangsspannung $U_e$. Werden beispielsweise aus dem zu filternden Eingangssignal $U_e$ als erstes Signal $U_1$ ein Signal verwendet, das um den Faktor K gegenüber $U_e$ verkleinert ist und als zweites Signal $U_2$ das Eingangssignal $U_e$ verwendet, so ergibt sich die Übertragungsfunktion des Filters zu

$$\frac{U_a}{U_e} = K \times (1-H(s)) + H(s),$$

wobei H(s) die Übertragungsfunktion der frequenzabhängigen Einrichtung bezeichnet. Die einstellbare Flankensteilheit des Filters ergibt sich durch die Wahl der ersten und zweiten Eingangssignale U1 und U2, deren Differenz vom Anwender des Filters frei bestimmbar ist.

Die Erfindung wird im folgenden anhand von fünf Figuren eingehend erläutert. Es zeigen:

FIG 1   ein prinzipielles Blockschaltbild eines erfindungsgemäßen Filters,

FIG 2   eine Schaltungsanordnung zu FIG 1 in Form einer integrierten Schaltung mit einer anschließbaren frequenzabhängigen Einrichtung,

FIG 3   eine Übertragungsfunktion eines erfindungsgemäßen Filters nach FIG 1 und 2 mit einer möglichen ersten Dimmensionierung der frequenzabhängigen Einrichtung,

FIG 4   ein erfindungsgemäßes Filter nach FIG 1 und 2 mit einer zweiten möglichen Dimmensionierung der frequenzabhängigen Einrichtung und

FIG 5   ein erfindungsgemäßes Filter nach FIG 1 und 2 mit einer RC-Kombination einer frequenzabhängigen Einrichtung.

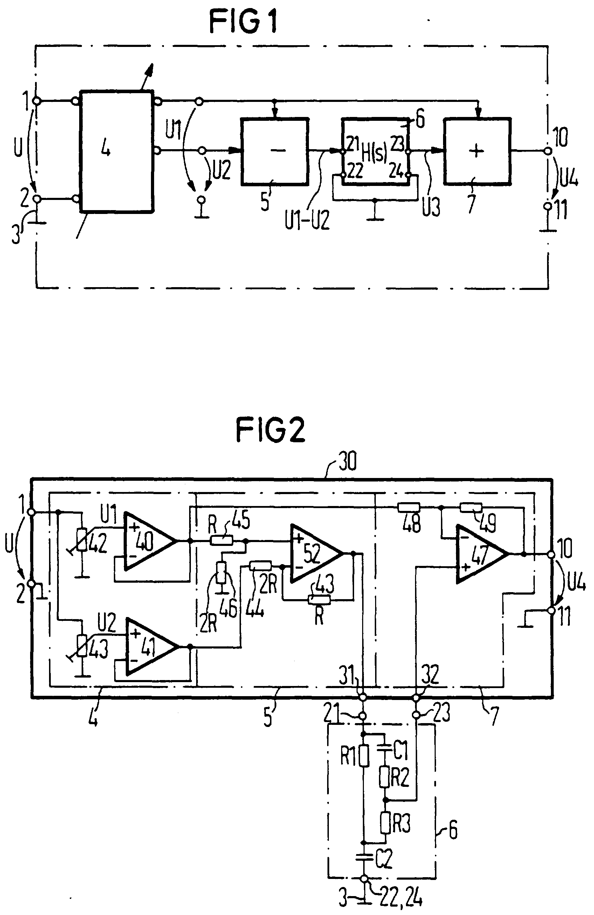

In FIG 1 ist ein Blockschaltbild eines erfindungsgemäßen Filters Illit einstellbarer Flankensteilheit dargestellt. Das Filter weist auf:

- Eingangsklemmen 1, 2 zum Anlegen eines zu filternden Signales U, wobei eine Eingangsklemme 2 mit einem Bezugspotential 3 verbunden ist;

- eine Einrichtung 4 zum Bilden eines ersten Signales U1, aus dem zu filternden Signal U und eines zweiten Signales U2 aus dem zu filternden Signal U, wobei eine Differenz zwischen erstem Signal U1 und zweitem Signal U2 einstellbar ist;

- eine Subtraktionseinrichtung 5 zum Bilden eines Differenzsignales U1-U2 aus dem ersten Signal U1 und dem zweiten Signal U2;

- einer frequenzabhängigen Einrichtung 6 mit einer Filterübertragungscharakteristik H(s) der das Differenzsignal U1-U2 zuführbar ist;

- eine Additionseinrichtung 7 zum Bilden eines Summensignales U4 aus dem ersten Signal U1 und einem an einem Ausgang 23 der frequenzabhängigen Einrichtung 6 abgreifbaren Signal U3; und

- Ausgangsklemmen 10, 11, von denen eine Ausgangsklemme 10 mit einem Ausgang der Additionseinrichtung 7 und eine andere Ausgangsklemme 11 mit Bezugspotential 3 verbunden ist.

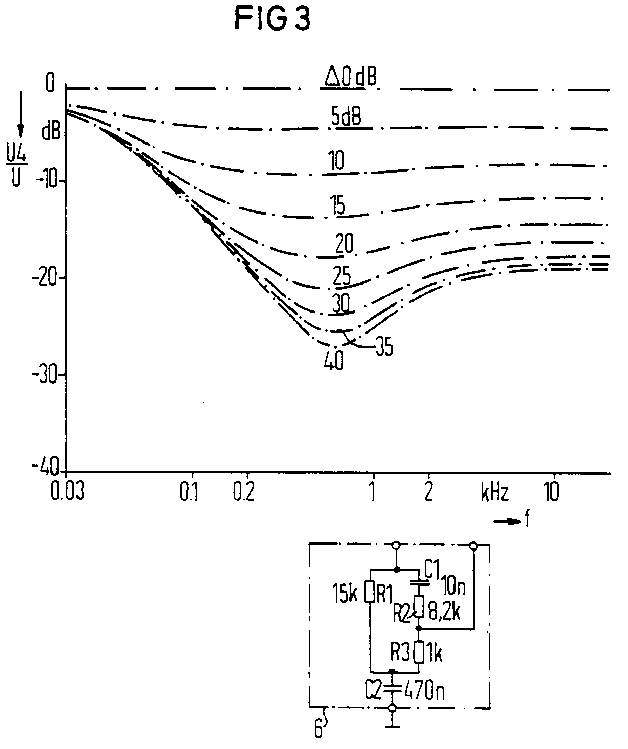

Die Einstellbarkeit der Differenz zwischen dem ersten Signal U1 und dem zweiten Signal U2 ist in FIG 1 durch den Pfeil an der Einrichtung 4 angedeutet. Wie im Zusammenhang mit den Figuren 3 bis 5 noch eingehend erläutert werden wird, ergibt sich je nach Wahl der Differenz des ersten Signals U1 zum zweiten Signal U2 eine andere Übertragungscharakteristik des Filters, das besonders zur physiologischen Lautstärkeregelung geeignet ist.

Die frequenzabhängige Einrichtung 6 ist als Vierpol ausgebildet und verfügt über zwei Eingangsklemmen 21, 22 und zwei Ausgangsklemmen 23, 24, von denen eine Ausgangsklemme 24 und eine Eingangsklemme 22 gemeinsam an das Bezugspotential 3 angeschlossen sind.

FIG 2 zeigt ein Ausführungsbeispiel für eine integrierte Schaltung 30, in die die Einrichtung 4 zum Bilden des ersten Signales U1 und zweiten Signales U2 die Subtraktionseinrichtung 5 sowie die Additionseinrichtung 7 integriert ist. Die Einrichtung 4 weist zwei parallelgeschaltete, jeweils als Spannungsfolger geschaltete Operationsverstärker 40, 41 auf, denen über einstellbare Widerstände 42, 43 das erste Signal U1 bzw. das zweite Signal U2 zuführbar ist. Über die einstellbaren Widerstände 42, 43 werden das erste Signal U1 und das zweite Signal U2 aus dem an den Klemmen 1 und 2 anliegenden zu filternden Signal U gewonnen. Die Subtraktionseinrichtung 5 verfügt über einen Operationsverstärker 52, der als invertierender Verstärker geschaltet ist. Dazu ist der Ausgang des Operationsverstärkers 52 mit seinem Minuseingang über einen Widerstand 43 verbunden. Der Minuseingang des Operationsverstärkers 52 ist zugleich über einen weiteren Widerstand 44 mit einem Ausgang des Operationsverstärkers 41, an dem das zweite Signal U2 abgreifbar ist, verbunden. Ein Pluseingang des Operationsverstärkers 52 ist über einen weiteren Widerstand 45 mit einem Ausgang des Operationsverstärkers 40, an dem das erste Signal U1 abgreifbar ist, verbunden. Zugleich liegt der Pluseingang des Operationsverstärkers 52 über einen weiteren Widerstand 46 auf Bezugspotential. Damit wirkt der Operationsverstärker 42 als Subtrahierer. Die Widerstandsverhältnisse der Widerstände 46 zu 45 und 43 zu 44 sind vorzugsweise gleich gewählt. In diesem Ausführungsbeispiel betragen der Widerstandswert der Widerstände 45 und 43 jeweils R und der Widerstandswert der Widerstände 44 und 46 2R. Ausgangsseitig ist der Operationsverstärker 52 der Subtraktionseinrichtung 5 mit einer Klemme 31 der integrierten Schaltung 30 verbunden. Darüber hinaus verfügt die integrierte Schaltung von FIG 2 über eine weitere Klemme 32. Diese Klemme 32 ist mit einem Pluseingang eines als Additionseinrichtung 7 geschalteten Operationsverstärkers 47 in Verbindung. Ein Minuseingang dieses Operationsverstärkers 47 ist mit einem Verbindungspunkt zweier Widerstände 48, 49 verbunden. Der Widerstand 48 liegt zwischen dem Ausgang des Operationsverstärkers 40 und dem Minuseingang des Operationsverstärkers 47. Der Widerstand 49 ist zwischen den Minuseingang und einen Ausgang des Operationsverstärkers 47 geschaltet. Der Ausgang des Operationsverstärkers 47 ist mit der Ausgangsklemme 10 des Filters in Verbindung. Die Ausgangsklemme 11 liegt auf Bezugspotential.

Damit enthält die integrierte Schaltung 30 die Einrichtung 4 zum Bilden des ersten Signales U1 und des zweiten Signales U2, die Subtraktionseinrichtung 5 und die Additionseinrichtung 7. Um das erfindungsgemäße Filter zu realisieren, wird die frequenzabhängige Einrichtung 6 an die Klemmen 31 und 32 der integrierten Schaltung 30 angeschlossen.

Die frequenzabhängige Einrichtung 6 ist in dem Ausführungsbeispiel von FIG 2 so ausgebildet, daß zwischen die Klemme 31 der integrierten Schaltung 30 und Bezugspotential 3 ein Widerstand R1 und ein Kondensator C2 in Reihe liegt. Parallel zum Widerstand R1 liegt die Reihenschaltung eines Kondensators C1 mit einem Widerstand R2 und einem weiteren Widerstand R3. Ein Verbindungspunkt zwischen dem Widerstand R2 und dem Widerstand R3 ist mit einer Ausgangsklemme 23 der frequenzabhängigen Einrichtung 6 in Verbindung. Diese Ausgangsklemme 23 ist mit der Klemme 32 der integrierten Schaltung 30 in Verbindung. Die Eingangsklemme 21 der frequenzabhängigen Einrichtung 6 ist einerseits mit der Klemme 31 der integrierten Schaltung 30 und andererseits mit dem Widerstand R1 und dem Kondensator C1 verbunden. Der Kondensator C2 ist mit der anderen Eingangsklemme 22 und der anderen Ausgangsklemme 24 - die in FIG 2 der Einfachheit halber nur als eine Klemme gezeichnet sind - angeschlossen.

Werden die Schaltelemente R1, R2, R3, C1 und C2 in folgender Weise dimensioniert

R1 = 15 kOhm,
R2 = 8,2 kOhm,
R3 = 1 kOhm,
C1 = 10 nF,
C2 = 470 nF,

so ergibt sich für das erfindungsgemäße Filter eine Übertragungsfunktion, wie sie in FIG 3 dargestellt ist. In FIG 3 sind auf der Abszissenachse in logarithmischem Maßstab die Frequenz f und in der Ordinatenachse die Übertragungsfunktion und damit das Verhältnis des Ausgangssignales U4 zum Eingangssignal U des Filters in dB aufgetragen. Die Übertragungsfunktion ist in Abhängigkeit vom Differenzsignal U1 - U2 dargestellt und zwar für die Differenzsignale 0 dB, 5 dB, 10 dB, 15 dB, 20 dB, 25 dB, 30 dB, 35 dB und 40 dB.

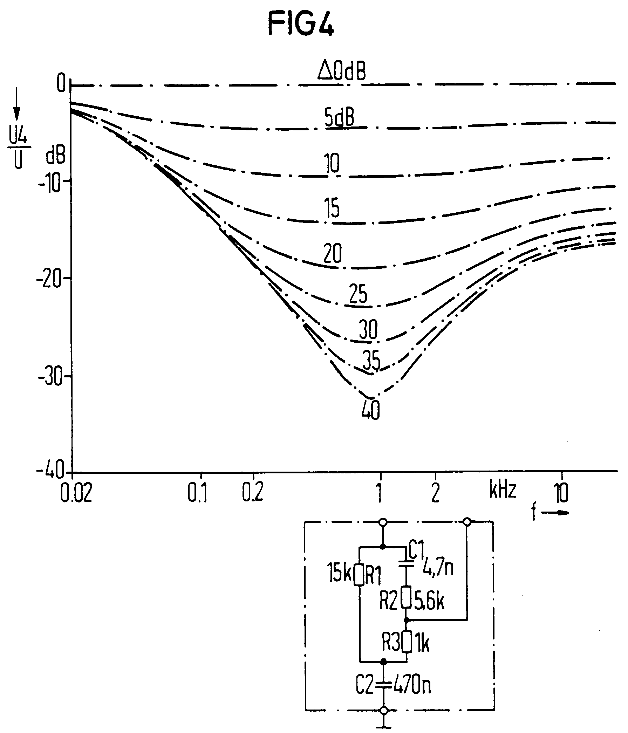

In FIG 4 ist ebenfalls eine Übertragungsfunktion eines erfindungsgemäßen Filters dargestellt, bei der als frequenzabhängige Einrichtung 6 prinzipiell die gleiche Schaltungsanordnung wie in FIG 3 bzw. FIG 2 eingesetzt ist. Es sind jetzt lediglich der Kondensator C1 und der Widerstand R2 im Vergleich zu FIG 3 anders dimensioniert. Der Kondensator C1 weist jetzt einen Kapazitätswert von 4,7 nF und der Widerstand R2 einen Widerstandswert von 5,6 kOhm auf. Mit dieser Dimensionierung ergibt sich die in FIG 4 oben dargestellte Übertragungscharakteristik, aus der deutlich zu erkennen ist, daß die Lautstärkeabsenkung im Bereich von 1 kHz stärker ist als in FIG 3.

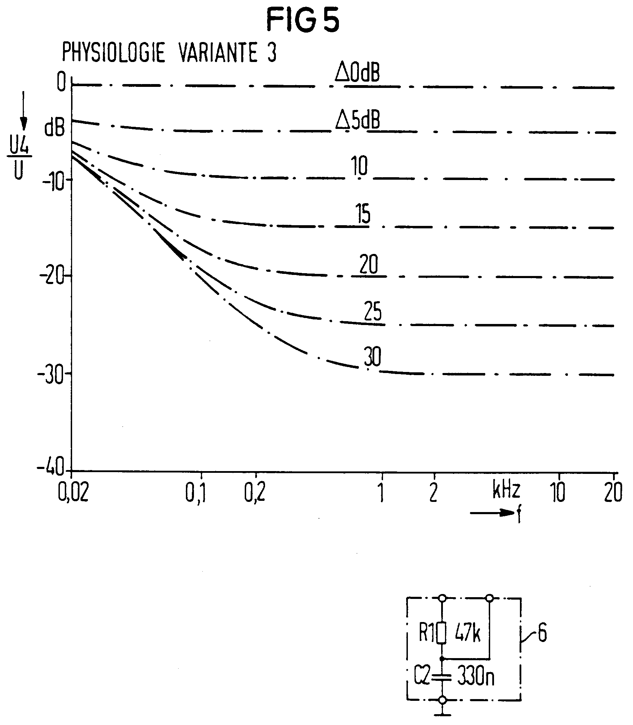

In FIG 5 wird als frequenzabhängige Einrichtung 6 lediglich ein RC-Glied mit dem Widerstand R1 und dem Kondensator C2 vorgestellt. Zwischen der Eingangsklemme 21 und dem Bezugspotential 3 sind der Widerstand R1 und der Kondensator C1 in Reihe geschaltet. Die Ausgangsklemme 23 der frequenzabhängigen Einrichtung ist mit dem Verbindungspunkt des Widerstandes R1 und dem Kondensator C2 verbunden, wobei der Kondensator auf Bezugspotential liegt. Der Widerstand R1 weist einen Widerstandswert von 47 kOhm und der Kondensator C2 einen Kapazitätswert von 33 nF auf. Beim Einsatz einer solchen frequenzabhängigen Einrichtung 6 ergibt sich die in FIG 5 oben dargestellte Übertragungscharakteristik.

Anzumerken ist noch, daß als frequenzabhängige Einrichtung 6 in den FIG 2, 3 und 4 ein Vierpol eingesetzt wird, der sich allgemein aus der Übertragungsfunktion

$$H(s) = \frac{1+A\,p+B\,p^2}{1+C\,p+D\,p^2}$$

ausdrücken läßt, wobei A, B, C und D Konstanten sind und p die Laplace-Konstante ist.

Die frequenzabhängige Einrichtung von FIG 5 hat allgemein ausgedrückt die Übertragungsfunktion

$$H(s) = \frac{1}{1+p\,R\,C},$$

wobei p wieder die Laplace-Konstante kennzeichnet und R ein Widerstandswert und C ein Kapazitätswert sind.

Das erfindungsgemäße Filter läßt sich vorteilhaft zur physiologischen Lautstärkeregelung von Audiosignalen verwenden. Im Gegensatz zu den bisher bekannt gewordenen physiologischen Lautstärkeregelungen wird die Lautstärkeregelung jetzt nicht mehr von der Klangregelung beeinflußt. Darüber hinaus kann als frequenzabhängige Einrichtung eine unsymmetrische Einrichtung, also eine solche mit Bezugspotentialanschluß, vorgesehen werden. Zudem reicht es aus, wie in FIG 2 dargestellt, daß zwei Anschlüsse in der integrierten Schaltung bereitgestellt werden, um das frequenzabhängige Netzwerk an die integrierte Schaltung anzuschließen.

**Patentansprüche**

1. Filter mit einstellbarer Flankensteilheit und

   - Eingangsklemmen (1, 2) zum Anlegen eines zu filternden Signales (U), wobei eine Eingangsklemme (2) mit einem Bezugspotential (3) verbunden ist;
   - einer Einrichtung (4) zum Bilden eines ersten Signales (U1), aus dem Signal (U) und eines zweiten Signales (U2) aus dem Signal (U), wobei eine Differenz zwischen erstem Signal (U1) und zweitem Signal (U2) einstellbar ist;
   - einer Subtraktionseinrichtung (5) zum Bilden eines Differenzsignales (U1-U2) aus dem ersten Signal (U1) und dem zweiten Signal (U2);
   - einer frequenzabhängigen Einrichtung (6) mit einer Filterübertragungscharakteristik (H (s)), der das Differenzsignal (U1-U2) zuführbar ist;
   - einer Additionseinrichtung (7) zum Bilden eines Summensignales (U4) aus dem ersten Signal (U1) und einem an einem Ausgang (23) der frequenzabhängigen Einrichtung (6) abgreifbaren Signal (U3); und
   - Ausgangsklemmen (10, 11), von denen eine Ausgangsklemme (10) mit einem Ausgang der Additionseinrichtung (7) und eine andere Ausgangsklemme (11) mit Bezugspotential (3) verbunden ist.

2. Filter nach Anspruch 1,
   **dadurch gekennzeichnet,**
   daß die frequenzabhängige Einrichtung (6) als Vierpol mit zwei Eingangsklemmen (21, 22) und zwei Ausgangsklemmen (23, 24) ausgebildet ist, von denen eine Ausgangsklemme (24) und eine Eingangsklemme (22) mit Bezugspotential (3) verbunden sind.

3. Filter nach Anspruch 1 oder 2,
   **dadurch gekennzeichnet,**
   daß als frequenzabhängige Einrichtung (6) ein Vierpol mit der Übertragungsfunktion

   $$H(s) = \frac{1}{1+p\,R\,C}$$

   vorgesehen ist, wobei p = Laplace-Konstante, R = ein Widerstandswert und C = ein Kapazitätswert sind.

4. Filter nach Anspruch 1 oder 2,
   **dadurch gekennzeichnet,**
   daß als frequenzabhängige Einrichtung (6) ein Vierpol mit der Übertragungsfunktion

   $$H(s) = \frac{1+A\,p+B\,p^2}{1+C\,p+D\,p^2}$$

   vorgesehen ist, wobei A, B, C und D Konstanten sind und p die Laplace-Konstante ist.

5. Filter nach einem der Ansprüche 1 bis 4,
   **dadurch gekennzeichnet,**
   daß das Filter als eine die Einrichtung (4), die Subtraktionseinrichtung (5) und die Additionseinrichtung (7) enthaltende integrierte Schaltung (30) ausgebildet ist und daß diese integrierte Schaltung (30) zwei Klemmen (31, 32) aufweist zum Anschluß der frequenzabhängigen Einrichtung (6).

6. Verwendung des Filters nach einem der Ansprüche 1 bis 5 zur physiologischen Lautstärkeregelung von Audiosignalen.

## Claims

1. Filter having adjustable edge gradient and

   - input terminals (1, 2) for the application of a signal (U) which is to be filtered, one input terminal (2) being connected to a reference-earth potential (3);
   - a device (4) for forming a first signal (U1) from the signal (U) and a second signal (U2) from the signal (U), a difference between the first signal (U1) and the second signal (U2) being adjustable;
   - a subtraction device (5) for forming a difference signal (U1-U2) from the first signal (U1) and the second signal (U2);
   - a frequency-dependent device (6) having a filter transmission characteristic (H (s)) to which the difference signal (U1-U2) can be supplied;
   - an addition device (7) for forming a sum signal (U4) from the first signal (U1) and a signal (U3) which can be picked up at an output (23) of the frequency-dependent device (6); and
   - output terminals (10, 11), of which one output terminal (10) is connected to an output of the addition device (7) and another output terminal (11) is connected to the reference-earth potential (3).

2. Filter according to Claim 1, characterized in that the frequency-dependent device (6) is designed as a four-pole network having two input terminals (21, 22) and two output terminals (23, 24), of which one output terminal (24) and one input terminal (22) are connected to the reference-earth potential (3).

3. Filter according to Claim 1 or 2, characterized in that a four-pole network having the transfer function

$$H(s) = \frac{1}{1 + p\,R\,C}$$

is provided as the frequency-dependent device (6), where p = Laplace constant, R = a resistance value and C = a capacitance value.

4. Filter according to Claim 1 or 2, characterized in that a four-pole network having the transfer function

$$H(s) = \frac{1 + A\,p + B\,p^2}{1 + C\,p + D\,p^2}$$

is provided as the frequency-dependent device (6), where A, B, C and D are constants and p is the Laplace constant.

5. Filter according to one of Claims 1 to 4, characterized in that the filter is designed as an integrated circuit (30) which contains the device (4), the subtraction device (5) and the addition device (7), and in that this integrated circuit (30) has two terminals (31, 32) for the connection of the frequency-dependent device (6).

6. Use of the filter according to one of Claims 1 to 5 for physiological volume control of audio signals.

## Revendications

1. Filtre, dont la pente des flancs est réglable, comportant

   - des bornes d'entrée (1,2) servant à appliquer un signal à filtrer (U), une borne d'entrée (2) étant reliée à un potentiel de référence (3);
   - un dispositif (4) destiné à former un premier signal (U1) à partir du signal (U) et à former un second signal (U2) à partir du signal (U), une différence entre le premier signal (U1) et le second signal (U2) pouvant être réglée;
   - un dispositif soustracteur (5) destiné à former un signal de différence (U1-U2) entre le premier signal (U1) et le second signal (U2);
   - un dispositif (6), qui dépend de la fréquence, qui a une caractéristique de transfert de filtre (H(s)) et auquel peut être envoyé le signal de différence (U1 - U2);
   - un circuit additionneur (7) destiné à former un signal de somme (U4) à partir du premier signal (U1) et d'un signal (U3) pouvant être prélevé sur une sortie (23) du dispositif (6) qui dépend de la fréquence; et
   - des bornes de sortie (10,11), dont l'une (10) est reliée à une sortie du circuit additionneur (7) et dont une autre (11) est reliée au potentiel de référence (3).

2. Filtre suivant la revendication 1, caractérisé par le fait que le dispositif (6), qui dépend de la fréquence, est sous la forme d'un quadripôle comportant deux bornes d'entrée (21,22) et deux bornes de sortie (23,24), parmi lesquelles une borne de sortie (24) et une borne d'entrée (22) sont reliées au potentiel de référence (3).

3. Filtre suivant la revendication 1 ou 2, caractérisé par le fait qu'il est prévu, comme dispositif (6) qui dépend de la fréquence, un quadripôle ayant la fonction de transfert

$$H(s) = \frac{1}{1 + p\,R\,C}$$

avec p = constante de Laplace, R = valeur résistive et C = valeur capacitive.

4. Filtre suivant la revendication 1 ou 2, caractérisé par le fait qu'il est prévu, comme dispositif (6) dépendant de la fréquence un quadripôle ayant la fonction de transfert

$$H(s) = \frac{1 + A\,p + B\,p^2}{1 + C\,p + D\,p^2}$$

A, B, C et D étant des constantes et p la constante de Laplace.

5. Filtre suivant l'une des revendications 1 à 4, caractérisé par le fait que le filtre est sous la forme d'un circuit intégré (30), qui contient le dispositif (4), le dispositif soustracteur (5) et le dispositif additionneur (7), et que ce circuit intégré (30) comporte deux bornes (31,32) pour le raccordement du dispositif (6) qui dépend de la fréquence.

6. Utilisation du filtre suivant l'une des revendications 1 à 5, pour le réglage physiologique de l'intensité sonore de signaux audio.

# FIG 1

# FIG2

# FIG 3

FIG4

FIG 5